# EUROPEAN PATENT APPLICATION

(11) **EP 1 333 479 A1**
(43) Date of publication of application: **06.08.2003**
(21) Application number: 02002271.1
(22) Date of filing: 30.01.2002
(51) Int. Cl.: H01L 21/336, H01L 29/788, G11C 16/04, G11C 16/10

(54) **Channel write/erase flash memory cell and its manufacturing method**

(71) Applicant: eMemory Technology Inc., Hsinchu, Taiwan, R.O.C. (TW)
(72) Inventor: Hsu, Ching-Hsiang, Hsin-Chu City, Taiwan, R.O.C. (TW); Yang, Ching-Sung, Chang-Hua Hsien, Taiwan, R.O.C. (TW)
(74) Representative: Grünecker, Kinkeldey, Stockmair & Schwanhäusser Anwaltssozietät

(57) **Abstract**

A flash memory cell (40) includes a parasitic capacitor (46) near the drain terminal (56) of the flash memory cell (40) can be charged in few microseconds during operation. Interference generated between the floating gate (54) and the source (64) is avoided by using a first oxide layer (48) which is thicker at the interface between floating gate (54) and source (64) and thinner near central part under stacked gate (50).

## Description

The present invention relates to a channel write/erase flash memory cell according to the pre-characterizing clause of claim 1.

Flash memories have the property of being electrically programmable and erasable, and because of their usefulness, they are widely applied in electronic products such as portable computers and communication equipment. In general, flash memory cells can be divided into two types: a stacked gate type and a split gate type, according to the structure of their gates.

Flash memory cells of both stacked gate type and split gate type are arranged in an array, and each memory cell usually stores one bit of information. In each memory cell, a source and a drain are formed in an n-type or a p-type silicon substrate . A tunneling dielectric layer is formed between the source and the drain. A floating gate and a controlling gate, separated by an insulating layer, are formed on the tunneling dielectric layer. The floating gate is used for storing an electrical charge and the controlling gate is used to control the accessing and storing of information. Additionally, memory cells are isolated from one another by field oxide layers or shallow trench isolation. In order to enhance the efficiency of the programming and erasing of flash memories, a memory cell with a larger area for the purpose of obtaining a high coupling ratio is required. However, a memory cell with too large of an area is difficult to integrate with other components.

This in mind, the present invention aims at providing a corresponding channel write/erase flash memory cell structure and also a new programming method.

This is achieved by a channel write/erase flash memory cell structure according to claim 1. The dependent claims pertain to corresponding further developments and improvements.

As will be seen more clearly from the detailed description following below, the claimed channel write/erase flash memory cell structure has a parasitic capacitor. Accordingly, when the flash memory is programmed, the parasitic capacitor can be charged in few microseconds so as to speed up the flash memory. And interference generated between a floating gate and a source is avoided by using an oxide layer which is thicker at the interface between the floating gate and the source and thinner near the central part under the stacked gate.

In the following, the invention is further illustrated by way of example, taking reference to the accompanying drawings. Thereof
Fig. 1 is a cross-sectional view of a conventional flash memory cell,
Fig.2 is a schematic diagram depicting a series of memory cells,
Fig.3 is a cross-sectional view showing the structure of the channel write/erase flash memory cell according to the present invention,
Fig.4 is an equivalent circuit of the channel write/erase flash memory cell shown in Fig.3, and
Fig.5 is a circuit diagram showing the pseudo-dynamic operation of the channel write/erase flash memory cell according to the present invention.

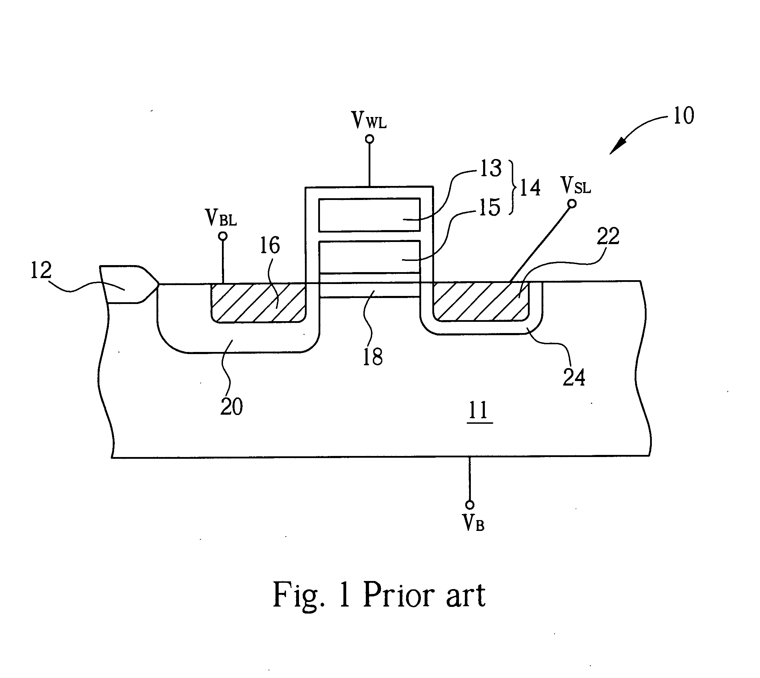

The prior art memory cell is disclosed in U.S. Pat. No. 6,214,668. Fig.1 is a cross-sectional view of a conventional flash memory cell 10. It includes a substrate 11, a first field oxide layer 12, a stacked gate 14, an N-type doping region 16, a shallow P-type doping region 18, a deep P-type doping region 20, and a source region 22.

The stacked gate 14 includes a control gate 13 and a floating gate 15 under the control gate 13. The N-type doping region 16 is formed between the first field oxide layer 12 and the stacked gate 14. The shallow P-type doping region 18 is formed next to the N-type doping region 16 and under the stacked gate 14. The deep P-type doping region 20 and the shallow P-type region 18 are doped with the same type of dopants. The deep P-type doping region 20 is formed under the N-type doping region 16 and is in contact with the first field oxide layer 12 and also the shallow P-type doping region 18. The deep P-type doping region 20 functions as a P well and its well depth is much deeper than the well depth of the shallow P-type doping region 18. The deep P-type doping region 20 and the N-type doping region 16 are electrically connected which functions as a drain terminal of the flash memory cell 10. The source region 22, functioning as a source terminal of the flash memory cell 10, is formed next to the shallow P-type region 18. Additionally, under the source region 22 a lightly doped region 24 is formed which is doped with the same type of dopants like the source region 22 but with a lighter density.

The programming method of the flash memory cell 10 will be explained below. When programming the flash memory cell 10, a word line voltage V_{WL}=-10V is applied to the control gate 13, a bit line voltage V_{BL}=5V is applied to the drain terminal, i.e. the shorted N-type doping region 16 and the deep P-type doping region 20, and no voltage is applied to the source terminal 22 so as to make it floating. Under this programming condition, electrons will eject from the floating gate 15 to the drain terminal due to the edge Fowler-Nordheim effect thereby achieving the effect of programming the flash memory cell 10.

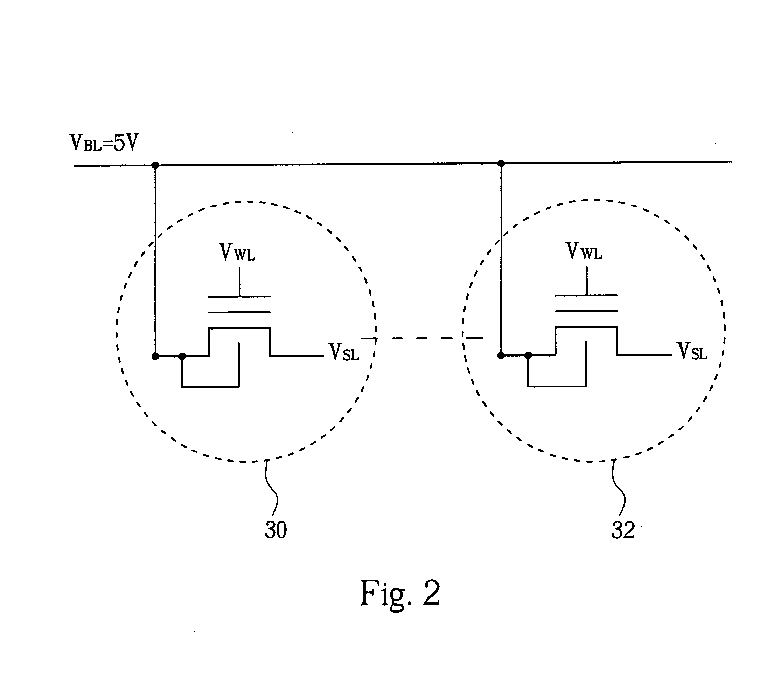

However, in the above conventional programming method, a series of flash memory cells are programmed in a cell-by-cell sequence. As shown in Fig.2, two flash memory cells 30 and 32 arranged in parallel are shown. Typically, it takes about 4ms to complete the programming of one flash memory cell when a bit line voltage V_{BL}=5V is applied to the flash memory cells 30 and 32. If 10 parallel flash memory cells are to be programmed, it will take 40 ms (10*4ms) to complete the programming job. It means a great deal of time is needed when using the conventional programming method. Consequently, there is a need to provide a more effective flash memory structure and programming method.

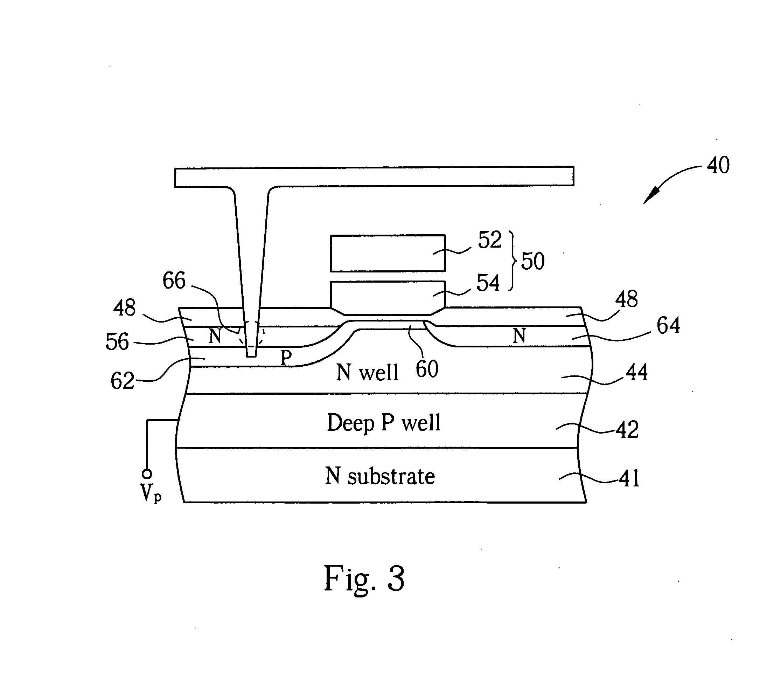

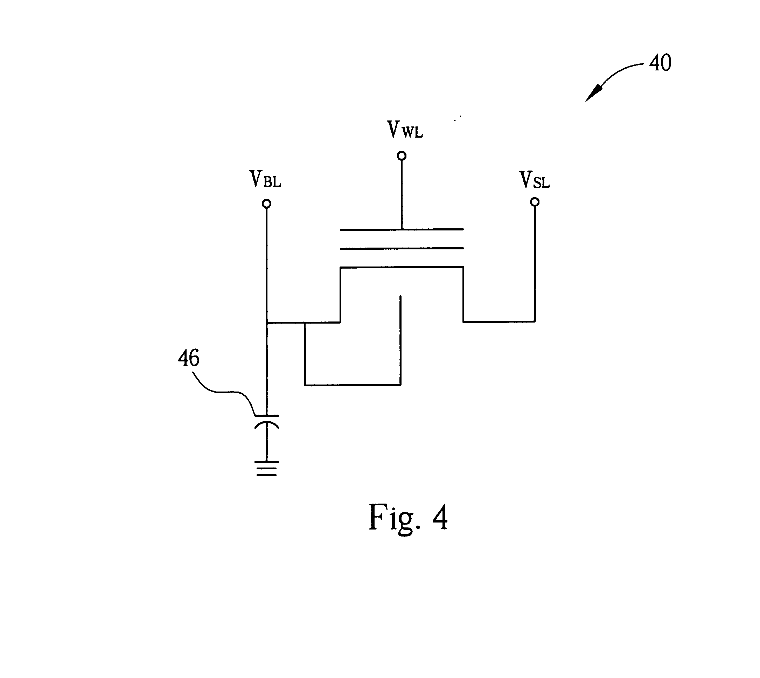

Fig.3 is a cross-sectional view showing the structure of the channel write/erase flash memory cell 40 and Fig.4 shows the equivalent circuit of the flash memory cell 40. The flash memory cell 40 is built upon an N substrate 41 which comprises a deep P well 42 above the N substrate 41 and a N well 44 above the deep P well 42. The deep P well 42 and the N well 44 constitute a parasitic capacitor 46 (shown in the equivalent circuit diagram) that facilitates the programming speed of the flash memory cell 40. The parasitic capacitor 46 will be discussed in detail hereinafter.

A first oxide layer 48 is formed over the N well 44, and a stacked gate 50 having a control gate 52 and a floating gate 54 is formed partially over the first oxide layer 48. An N doping region 56 acting as a drain terminal is formed under the first oxide layer next to the stacked gate 50. A shallow P doping region 60 is formed under the stacked gate 50 and next to the N doping region 56. A deep P doping region 62 is formed underneath the N doping region 56 and is contiguous with the P doping region 60. An N doping region 64 acting as a source is formed under the first oxide layer 48 and next to the shallow P doping region 60.

To avoid undesired interference between the floating source and the floating gate 54, the thickness of the first oxide layer 48 at the interface between the N doping region 64 and the floating gate 54 is thicker than the thickness near the central part under the stacked gate 50. That is, the first oxide layer 48 extends into the stacked gate 50 with a decreasing thickness. Such a design can avoid electrons ejection from the floating gate 54 to the high voltage source end. The N doping region 56 and the deep P doping region 62 are short-circuited together (marked in dash line 66) by a metal contact penetrating through the N doping region 56 to the deep P doping region 62. This prevents hot holes generated in the depletion region of the deep P doping region 62 from injecting into the floating gate 54 in the presence of lateral electric field. Alternatively, a metal contact may be formed across the exposed N doping region 56 and the deep P doping region 62 to short-circuit these two regions.

In this preferred embodiment of the invention, the N doping regions 56 and 64 are doped with VA elements such as phosphorus and the shallow P doping region 60 and the deep P doping region 62 are doped with IIIA elements such as boron.

Table 1 shows exemplary operating modes of the channel write/erase flash memory cell 40 of this invention. When operating the flash memory cell 40, a word line voltage V_{WL}, a source line voltage V_{SL}, and a bit line voltage V_{BL} are applied, respectively, to the control gate 52, the source terminal 64, and the drain terminal 56 of the flash memory cell. As mentioned, N well 44, deep P well 42 and N substrate 41 is positioned in order under the flash memory cell 40. A well voltage V_{P} is applied to the deep P well 42. The N well 44 and the deep P well 42 constitute a parasitic capacitor 46 when programming the flash memory cell.

**Table 1**

| | V_{BL} | | V_{WL} | | V_{SL} | V_{P} |
|---|---|---|---|---|---|---|
| | selected | nonselected | selected | nonselected | | |
| program | 5V | 0V | -10V | floating | floating | 0V |
| erase | floating | floating | 10V | floating | -8V | -8V |
| read | 0V | floating | 3.3V | floating | 1V | 0V |

In table 1, when programs a selected memory cell, a low voltage V_{WL}=-10V is applied to the control gate of the selected memory cell, and the bit line voltage V_{BL} is higher than the word line voltage V_{WL}, for example, V_{BL}=5V. The source remains in a floating state (V_{SL}=floating). A well voltage V_{P}=0V is applied to the deep P well 42.

When erases the selected memory cell, the word line voltage V_{WL} (10V) is in a high voltage level, and the source line voltage V_{SL} (-8V) is in a voltage level relatively lower than the word line voltage V_{WL}, and the bit line voltage V_{BL} is floating. The well voltage V_{P} (-8V) and the source line voltage V_{SL} are the same.

When read the selected memory cell, the word line voltage V_{WL} (3.3V) is in a high voltage level, the source line voltage V_{SL} (1V) is in a voltage level relatively lower than the word line voltage V_{WL}, and the bit line voltage V_{BL} (0V) is in a voltage level relatively lower than the source line voltage V_{SL}. The well voltage V_{P} (0V) is in a voltage level lower than the source line voltage V_{SL}.

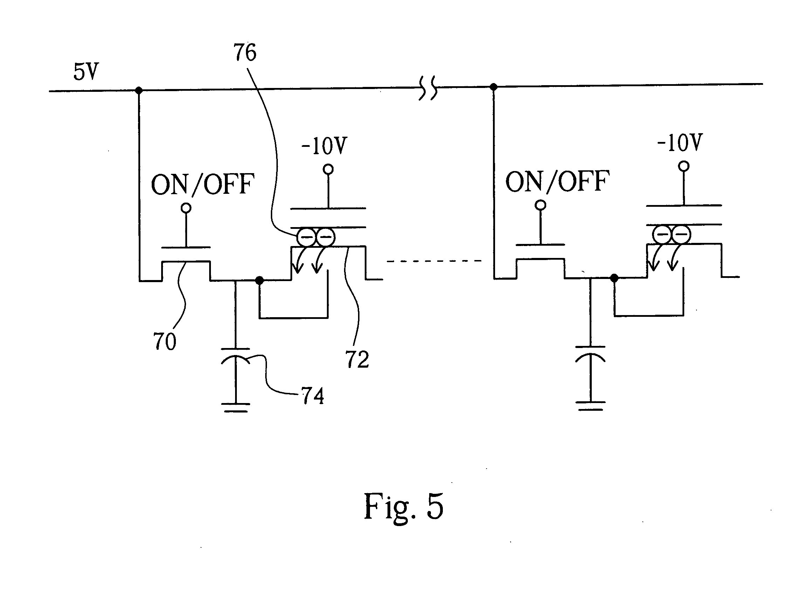

Fig.5 is a circuit diagram showing the pseudo-dynamic operation of the channel write/erase flash memory cell according to the present invention. A bit line voltage V_{BL} =5V is controlled by a selecting transistor 70. When the transistor 70 is turned on, the drain and the parasitic capacitor 74 are charged to 5V in few microseconds (µs), typically less than 10µs. The charged parasitic capacitor 74 is stand-by for subsequently ejecting electrons 76 from the floating gate to the drain. Unlike the conventional programming method which takes about 4ms to complete the programming of one flash memory cell, the pseudo-dynamic program operation saves a great deal of time.

In summary, the present invention has the following advantages when comparing with the above-mentioned conventional flash memory. First, the parasitic capacitor near the drain terminal can be charged in few microseconds. Second, interference generated between the floating gate and the source is avoided by using the first oxide layer which is thicker at the interface between floating gate and the source and thinner near the central part under the stacked gate. And third, hot hole injection is also avoided since the N doping region and the deep P doping region are short-circuited together.

## Claims

1. A channel write/erase flash memory cell (40) comprising:
a substrate (41) of a first conductivity type;
a stacked gate (50) formed over the substrate (41);
a doping region (56) of the first conductivity type acting as a drain formed within the substrate (41) and next to the stacked gate (50);
a shallow doping region (60) of second conductivity type formed under the stacked gate (50) and next to the doping region (56) of first conductivity type; and
a deep doping region (62) of second conductivity type formed underneath the doping region (56) of first conductivity type and being contiguous with the shallow doping region (60) of second conductivity type;
**characterized in**
**that** the channel write/erase flash memory cell (40) further comprises:
a first well region (42) of a second conductivity type formed above the substrate (41);
a second well region (44) of the first conductivity type formed above the first well region (42); and
a first oxide layer (48) formed on the second well region (44).

2. The channel write/erase flash memory cell (40) of claim 1 **characterized in that** the first conductivity type is N type and the second conductivity type is P type.

3. The channel write/erase flash memory cell (40) of claim 1 **characterized in that** the first oxide layer (48) extends into the stacked gate (50) with a decreasing oxide thickness to avoid undesired interference.

4. The channel write/erase flash memory cell (40) of claim 1 **characterized in that** the channel write/erase flash memory cell (40) further comprising a source doping region (64) acting as a source formed under the first oxide layer (48) and next to the shallow doping region (60) of second conductivity type.

5. The channel write/erase flash memory cell (40) of claim 1 **characterized in that** the doping region (56) of first conductivity type and the deep doping region (62) of second conductivity type are electrically short-circuited together.

6. The channel write/erase flash memory cell (40) of claim 5 **characterized in that** the short-circuit electrical connection (66) between the doping region (56) of first conductivity type and the deep doping region (62) of second conductivity type is obtained by using a metal contact that penetrates through the junction between the doping region (56) of first conductivity type and the deep doping region (62) of second conductivity type.

7. The channel write/erase flash memory cell (40) of claim 5 **characterized in that** the short-circuit electrical connection (66) between the doping region (56) of first conductivity type and the deep doping region (62) of second conductivity type is obtained by using a metal contact across exposed surface of the doping region (56) of first conductivity type and exposed surface of the deep doping region (62) of second conductivity type.

8. The channel write/erase flash memory cell (40) of claim 5 **characterized in that** the stacked gate (50) comprises a floating gate (54) and a control gate (52) positioned over the floating gate (54).

9. A pseudo-dynamic operating method for a channel write/erase flash memory cell (40) formed on an N substrate (41), a word line voltage V_{WL}, a source line voltage V_{SL}, and a bit line voltage V_{BL} being applied, respectively, to a control gate (52), a source terminal (64), and a drain terminal (56) of the flash memory cell (40);
**characterized in**
**that** the channel flash memory cell (40) further comprises an N well (44) and a deep P well (42) formed on the N substrate (41), a well voltage V_{P} is applied to the deep P well (42), the N well (44) and the deep P well (42) constituting a parasitic capacitor (46) during programming the flash memory cell (40), the pseudo-dynamic operating method comprising:
implementing an erase mode wherein the word line voltage V_{WL} is in a high voltage level, the source line voltage V_{SL} is in a voltage level relatively lower than the word line voltage V_{WL}, and the bit line voltage V_{BL} is floating, the well voltage V_{P} and the source line voltage V_{SL} being the same;
implementing a program mode wherein the word line voltage V_{WL} is in a low voltage level, the bit line voltage V_{BL} is in a voltage level relatively higher than the word line voltage V_{WL}, the source line voltage V_{SL} is floating, and the well voltage V_{P} is in a voltage level higher than the word line voltage V_{WL} but lower than the bit line voltage V_{BL}; and
implementing a read mode wherein the word line voltage V_{WL} is in a high voltage level, the source line voltage V_{SL} is in a voltage level relatively lower than the word line voltage V_{WL}, and the bit line voltage V_{BL} is in a voltage level relatively lower than the source line voltage V_{SL}, the well voltage V_{P} being in a voltage level lower than the source line voltage V_{SL}.

10. The pseudo-dynamic operating method of claim 9 **characterized in that** voltage applied to the word line is between about 8 to 10V, voltage applied to the source line is between about -12 to -8V, and voltage applied to the deep P well (42) is between about -12 to -8V when implementing the erase mode.

11. The pseudo-dynamic operating method of claim 9 **characterized in that** voltage applied to the word line is between about -12 to -8V, voltage applied to the bit line is between about 3 to 7V, and voltage applied to the deep P well (42) is 0V when implementing the program mode.

12. The pseudo-dynamic operating method of claim 9 **characterized in that** voltage applied to the word line is between about 2 to 5V, voltage applied to the bit line is between about -2 to 0V, voltage applied to the source line is between about 0 to 2V, and voltage applied to the deep P well (42) is 0V when implementing the read mode.

13. A flash memory cell (40) comprising:
a first well region (41) of a first conductivity type;
a stacked gate (50) formed over the first well region (41) ; a drain doping region (56) of the first conductivity type formed within the first well region (41) on a side of the stacked gate (50), the drain doping region (56) is electrically short-circuited with a doping region (62) of the second conductivity type that is formed within the first well region (41) and underneath the drain doping region (56); and
a source doping region (64) of the first conductivity type formed within the first well region (41) on the other side of the stacked gate (50);
**characterized in**
**that** the flash memory cell (40) further comprises:
a second well region (42) of a second conductivity type formed above the first well region (41);
a third well region (44) of the first conductivity type formed above the second well region (42); and
an oxide layer (48) formed on the third well region (44), the oxide layer (48) has a thickness near the edge of the stacked gate (50) that is thicker than the thickness near the center of stacked gate (50); and
**that** when programming the flash memory cell (40), the third well region (44) and second well region (42) constitute a parasitic capacitor (46) that is charged in few microseconds.

14. The flash memory cell (40) of claim 13 **characterized in that** the first conductivity type is N type and the second conductivity type is P type.

15. The flash memory cell (40) of claim 13 **characterized in that** the oxide layer (48) extends into the stacked gate (50) with a decreasing thickness to avoid undesired interference.

16. A flash memory cell (40) installed in a semiconductor wafer comprising:
a drain terminal formed in a first area of the semiconductor wafer;
a source terminal (64) formed in a second area of the semiconductor wafer not overlapped with the first area; and
a stacked gate (50) formed on the semiconductor wafer between the drain terminal and the source terminal (64), the stacked gate (50) having a floating gate (54) above the semiconductor wafer and a control gate (52) above the floating gate (54);
**characterized in**
**that** the flash memory cell (40) further comprises:
a first well (44) of a first conductivity type formed in the semiconductor wafer; and
a second well (42) of a second conductivity type formed beneath the first well (44) wherein a parasitic capacitor (46) is created by the first well (44) and the second well (42); and
**that** when programming the flash memory cell (40), the parasitic capacitor (46) is charged by applying a first voltage to the drain terminal, grounding the second well (42) and applying a second voltage to the control gate (52).

17. The flash memory cell (40) of claim 16 **characterized in that** when programming the flash memory cell (40), the first voltage is a positive voltage, the second voltage is a negative voltage, and the source terminal (64) is floating.

18. The flash memory cell (40) of claim 16 **characterized in that** the drain terminal comprises a first doping region (56) of the first conductivity type and a second doping region (62) of the second conductivity type encompassing the first doping region (56), and the first doping region (56) and second doping region (62) are electrically short-circuited together.

19. The flash memory cell (40) of claim 16 **characterized in that** the parasitic capacitor (46) is charged up to the first voltage when programming the flash memory cell (40).

20. The flash memory cell (40) of claim 16 **characterized in that** an oxide layer (48) is located under the floating gate (54) and extends into the floating gate (50) with a decreasing thickness to avoid undesired interference between the floating gate (54) and the source terminal (64).
